Europäisches Patentamt

European Patent Office

Office européen des brevets

(19)

(11) Publication number: **0 302 829**
**A2**

(12) **EUROPEAN PATENT APPLICATION**

(21) Application number: **88810520.2**

(22) Date of filing: **27.07.88**

(51) Int. Cl.⁴: **G 03 F 7/10**

(30) Priority: **05.08.87 GB 8718528**

(43) Date of publication of application:
**08.02.89 Bulletin 89/06**

(84) Designated Contracting States:
**BE CH DE FR GB IT LI NL**

(71) Applicant: **CIBA-GEIGY AG**
**Klybeckstrasse 141**
**CH-4002 Basel (CH)**

(72) Inventor: **Blyth, Jeffrey**
**7 Bath Street**
**Brighton BN1 3TB (GB)**

(54) **Photopolymerisable compositions.**

(57) There is described a photopolymerizable composition useful in the preparation of a hologram which comprises as a) the vinyl monomer, zinc di-acrylate, as b) the sensitising dye, a phenothiazine dye, as c) the photoinitiator, dimedone and as d) the binder either gelatin alone or gelatin with up to 40% of another water-soluble polymer.

EP 0 302 829 A2

## Description

### Photopolymerisable compositions

This invention relates to photopolymerizable compositions used in the production of holograms. A large number of photopolymerizable compositions are known. That is to say compositions which comprise a monomer, usually a vinyl monomer which polymerises when exposed to light in the presence of a sensitising dye and other components. Photopolymerizable compositions are finding increasing use in the production of photoresists and in the production of raised images for printing and other purposes. It has been proposed to prepare holograms from some of these photopolymerizable compositions but the qualities required to form a good bright hologram from a photopolymerizable composition are very different than those required for example to form a photoresist. In fact only very few photopolymerizable systems have been proposed from which fair, but not good, holograms can be prepared.

In general in a photopolymerizable composition from which a hologram can be prepared it is required to incorporate a) a vinyl monomer, b) a sensitising dye, c) a so-called photoinitiator which acts to promote polymerisation of the vinyl monomer in the presence of the dye which has been reduced by the light exposure and d) a binder for the composition.

We have found a composition which acts as a photopolymerization composition for the production of holograms.

According to the present invention there is provided a photopolymerizable composition useful in the preparation of a hologram which comprises as a) the vinyl monomer, zinc di-acrylate, as b) the sensitising dye, a phenothiazine dye, as c) the photoinitiator, dimedone and as d) the binder, gelatin containing 0 to 40% of another water soluble polymer.

Preferably the binder is gelatin alone. Other water-soluble binders which however may be present include polyvinyl alcohol, polyvinyl pyrrolidone, casein and albumin.

Examples of phenothiazine dyes are methylene blue, New Methylene blue and thionine. The first two are the preferred dyes.

In USP 3,488,269 the use of dimedone (5,5-dimethyl 1,3-cyclohexanedione) is included in the classes of compounds proposed to be used as photoinitiating agents in photopolymerizable compositions. In USP 3,488,269 the preferred sensitising dye appears to be thionine and examples are given of acrylates which can form a photopolymerizable composition which includes acetylacetone as the photoinitiator. It further states that dimedone is an effective photopolymerization initiator for the acrylamide-thionine system.

From a study of this patent one is led to the view that only very specific combinations of dyes, vinyl monomers and photoinitiators can be used in a photopolymerisable composition. There is certainly no suggestion that zinc acrylate can be present in a photopolymerizable composition which comprises dimedone and a sensitising dye. In fact instead of zinc acrylate we have tried various of the other vinyl monomers in our photopolymerizable composition. For example we have tried acrylates of the following metals calcium, strontium, magnesium, copper, iron and manganese.

A holographic image was obtained when the first three named acrylates were used but the holographic image was obscured by a severe white haze and could not be displayed. In the case of the last three acrylates named above no holographic image at all was obtained.

Instead of dimedone as the component c) of the composition of the present invention we tested various of the other photoinitiating agents mentioned in USP 3,488,269 including acetylacetone and ethyleneimine but none of these substitutions for dimedone yielded bright, clear, viewable holograms when the compositions were used to produce holograms after coating on to clear base and a holographic exposure. Further triethanolamine was found to produce a photopolymerizable composition which was not light sensitive enough.

Instead of methylene blue and New Methylene Blue as component b) of the composition of the present invention we tested the dye proposed in USP 3,488,269 which was thionine and we also tested riboflavin, eosin and erythosin which dyes have been proposed to be used in other photopolymerizable systems. But none of these dyes produced a photopolymerizable compositions which was sufficiently sensitive to be used in the production of holograms.

Finally we replaced gelatin as the binder component d) with a binder which comprised 80% by weight of low weight polyvinyl alcohol the remainder being gelatin. When this composition was coated, holographically exposed and processed a very poor hologram with much haze was produced. Further the composition had very low light sensitivity.

Also a further advantage of using gelatin as the binder is that aqeuous coating solutions can be prepared and coated on webs in a continuous manner as practised in the photographic industry. Further the gelatin coating solution dries down to produce a film coating which has a non-tacky surface. When the coated material is to be stored for a period it is advantageous that the gelatin coating solution comprises a hardener.

In such cases hardened gelatin coatings have advantages over non-hardened gelatin coatings when it comes to processing the exposed holographic material because the residual monomer can be leached out of the coating in a more controlled manner leading to a brighter holographic image due to an increase in broad band replay.

The prefered gelatin hardening agent is glyoxal.

Other binders such as polyacrylamide were also tried but it was difficult to formulate a stable coating composition using such binders and the resultant holograms were very poor.

Thus it became apparent to us that the photopolymerizable composition used to produce holograms observed by us was very specific in the ingredients used none of which could be altered or substituted by other components which have been described as of use in photopolymerizable compositions.

However it is to be understood that other optional ingredients can be included in the photopolymerizable composition of the present invention.

For example alkali metal hypophosphites may be present in the composition to reduce the laser exposure time required.

Other components which may be optionally present in the composition are for example surfactants such as alkyl sulphonates, alkylaryl sulphonates, polyalkoxylated phenols and other surfactants well known in the literature. Inhibitors may be present to ensure dark stability of the coated composition, examples being hydroquinone, p-methoxyphenol, or t-butyl catechol. Humactants may be present in order to allow better control over the moisture content of the coated layer during the necessary pre-exposure moisture activation step and these may include ethylene glycol, gylcerol, trimethylolpropane and other polyhydroxy compounds as well as other compounds known in the art.

The supporting base may be any transparent base used in the photographic industry for example glass biaxially oriented polyethylene terephthphate or polycarbonate or a cellulose derivative such as cellulose triacetate.

The photopolymerizable compositions of the present invention may be dispersed in an aqueous binder solution and then coated by the conventional techniques well known to the photographic industry by doctor bar, slot, cascade, curtain and dip, and the coated layers dried by normal hot air methods.

The coated assemblies may be stored essentially unchanged for several months under low moisture, low temperature conditions. Before exposure the coatings are activated by bringing them into a controlled humidity environment, whereupon sufficient moisture is absorbed to enable the photopolymerization to occur.

Exposure is to laser light especially laser light having a wavelength between 600 - 700 nm.

The exposed assemblies may be processed by the well known sequence of swelling in a hydrophilic bath (e.g. pure water) followed by shrinking and dehydration in a water-miscible solvent. The baths may contain, if desired, additional components, for example compounds which bring about an increase in the wavelength of the processed hologram or improved image stability. The dehydrated, exposed coatings may then be dried with warm air and laminated if required, to produce moisture stable holographic images.

The following Example will serve to illustrate the invention.

### EXAMPLE

The following aqueous solutions were prepared and used in the coatings as set forth below.

gelatin solution    20 g per 100 ml
hydroxy-ethyl cellulose solution    15 g per 100 ml
polyvinyl alcohol solution    20 g per 100 ml

zinc acrylate solution    25 g per 100 ml
calcium acrylate solution    25 g per 100 ml
strontium acrylate solution    25 g per 100 ml
magnesium acrylate solution    25 g per 100 ml
cupric acrylate solution    25 g per 100 ml
manganese acrylate solution    25 g per 100 ml
ferric acrylate solution    25 g per 100 ml
lithium acrylate solution    25 g per 100 ml

dimedone (as lithium salt) solution    15 g per 100 ml
triethanolamine solution    50 g per 100 ml
polyethyleneimine solution    50 g per 100 ml
sodium sulphite solution    50 g per 100 ml
ethylene diamine tetra.acetic acid    50 g per 100 ml solution
methylene blue solution    4 g per 100 ml
thionine solution    4 g per 100 ml
malachite green solution    4 g per 100 ml
New Methylene Blue solution    4 g per 100 ml

Providing the photopolymerizable composition of the present invention required the preparation and testing of a very large number of compositions and it is of course impossible to list all the compositions which were found not to be useful. However to illustrate the surprising superiority of the composition of the present invention we have set forth below compositions in which one of the ingredients a) vinyl monomer, b) sensitising dye, c) photoinitiator and d) binder are different to those of the composition of the present invention. But it is to be understood that other compositions were prepared in which at least two of a), b), c) and d) were different to the ingredients used in the composition of the present invention but none of these compositions were useful in like manner to those in which only one ingredient was different as detailed below.

The following coating solutions were prepared using the aqueous solutions as just set forth.

Compositions according to the present invention.

  1) 28 ml gelatin solution
  10 ml zinc acrylate solution
  2 ml methylene blue solution
  6 ml dimedone solution
  0.05 ml surfactant

  2) 28 ml gelatin solution
  10 ml zinc acrylate solution
  2 ml New Methylene Blue solution
  6 ml dimedone solution
  0.05 ml surfactant

Compositions the same as the compositions of the present invention except that a) the vinyl monomer was changed. Thus instead of 10 ml zinc acrylate solution there was present :

  3) 10 ml calcium acrylate solution
  4) 10 ml stontium acrylate solution

5) 10 ml magnesium acrylate solution
6) 10 ml cuprice acrylate solution
7) 10 ml manganese acrylate solution
8) 10 ml ferric acrylate solution
9) 10 ml lithium acrylate solution

Compositions the same as the compositions of the present invention except that b) the sensitising dye was changed. Thus instead of 4ml of methylene blue or 4ml of New Methylene Blue solution there was present :

10) 2 ml thionine solution
11) 2 ml malachite green solution

Compositions the same as the compositions of the present invention except that c) the photoinitiator was changed. thus instead of 6 ml of dimedone solution there was present :-

12) 6 ml triethanolamine solution
13) 6 ml polyethyleneimine solution
14) 6 ml sodium sulphite solution
15) 6 ml ethylene diamine tetra-acetic acid solution
16) 3 ml ethylene tetra-acetic acid and 3 ml triethanolamine solution

Compositions the same as the compositions of the present invention except that d) the binder was changed. Thus instead of 28 ml of gelatin solution there was present :-

17) 28 ml hydroxyethyl cellulose solution
18) 28 ml polyvinyl alcohol solution
19) 14 ml hydroxyethyl cellulose solution and 14 ml polyvinyl alcohol solution
20) 14 ml polyvinyl alcohol solution and 14 ml gelatin solution

All the above listed twenty coating compositions were coated under green safe-light conditions at 50°C on to glass plates. The coating were allowed to gel and then were warm air dried to give a coating thickness of 10 microns.

The coatings were stored for 24 hours at a relative humidity of 60% and there were holographically exposed using a Denisyuk exposure method and a helium/neon laser with a standard metallic test object.

The energy received by each coated plate during the holographic exposure was 25 m joules per cm². 

After the holographic exposure all the coated plates were processed as follows :

i) 1 minute soak in a water bath at 16°C with mild agitation,
ii) 20 seconds in an aqueous isopropyl alcohol bath at 16°C with strong agitation (water content 20 volume %) and
iii) 5 minutes in a dry isopropyl alcohol bath at 20°C (water content below 2 volume %)

Each plate was then warm air dried and the resultant hologram was examined.

## RESULTS

Compositions 1 and 2    In both cases a clear bright hologram without haze was obtained.

Compositions 3 and 4    In both cases holograms were obtained but the image was obscured by a severe white haze which rendered the hologram useless for display purposes.

Composition 5    A rather hazy not very bright hologram was obtained.

Compositions 6, 7 and 8    No hologram at all was obtained.

Composition 9    A hologram was obtained but the plate was hard to handle as the coating was very tacky and could not be dried properly.

Compositions 10 and 11    No holograms were obtained in either case.

Composition 12    Only a very faint hologram was obtained.

Composition 13    No hologram was obtained.

Composition 14    No hologram was obtained as the dye was bleached.

Composition 15    No hologram was obtained.

Composition 16    A very hazy hologram was obtained.

Composition 17    Coating composition difficult to coat and uneven coatings obtained because of this.

Composition 18    Coating composition difficult to coat.

Composition 19    Coating composition difficult to coat.

Composition 20    Coating composition unstable and the vinyl monomer started to come out of solution.

Thus as can be seen the only compositions which yielded clear, bright, non-hazy holograms were compositions 1 and 2 which are the compositions according to the present invention.

## Claims

1. A photopolymerizable composition useful in the preparation of hologram which comprises as a) the vinyl monomer, zinc di-acrylate, as b) the sensitising dye, a phenothiazine dye, as c) the photoinitiator, dimedone and as d) the binder gelatin containing 0 to 40 % of another water soluble polymer.

2. A photopolymerizable composition according to claim 1 wherein the phenothiazine dye is methylene blue or New Methylene Blue.

3. A photopolymerizable composition according to claim 1 wherein the binder is gelatin alone.

4. A photopolymerizable composition according to claim 1 wherein the gelatin has been hardened.

5. A photopolymerizable composition according to claim 4 wherein the gelatin has been hardened by the use of glyoxal.

6. A hologram which has been prepared using a composition as claimed in claim 1.